# EUROPEAN PATENT APPLICATION

(11) **EP 1 329 997 A1**
(43) Date of publication of application: **23.07.2003**
(21) Application number: 02250296.7
(22) Date of filing: 16.01.2002
(51) Int. Cl.: H01S 5/068, H01S 5/026

(54) **Laser light transmitter and laser light transceiver with laser diode with feed forward control**

(71) Applicant: LUCENT TECHNOLOGIES INC., Murray Hill, New Jersey 07974-0636 (US)
(72) Inventor: Heerze, Marieke Louise, 1339 GG Almere (NL); Helmerhorst, Henk Petrus, 1541 DW Koog aan de Zaan (NL); Van Dijk, Huibert Jan, 3751 XG Bunschoten (NL)
(74) Representative: Sarup, David Alexander

(57) **Abstract**

The invention relates to a laser light transmitter for an optical communication system. The laser light transmitter comprises a transmitter unit comprising a laser diode for transmitting a laser signal, a laser driver which is connected with the laser diode and a temperature sensor for measuring the temperature of the laser diode. The laser light transmitter further comprises a processing unit comprising a microprocessor and memory means which are connected with the microprocessor. In operation the laser driver controls the laser diode by providing the laser diode with a laser diode current wherein the laser light transmitter according to the invention is characterised in that the microprocessor is connected with the laser driver and with the temperature sensor such that the microprocessor controls the laser driver on the basis of predetermined characteristics of the laser diode and the measured temperature of the laser diode.

## Description

The invention relates to a laser light transmitter for an optical communication system, including a transmitter unit having a laser diode for transmitting a laser output signal, and a laser driver which is connected with the laser diode and a temperature sensor for temperature compensation purposes, wherein the laser light transmitter further includes a processing unit including a microprocessor and memory means which are connected with the microprocessor, wherein, in use, the laser driver controls the laser diode by providing the laser diode with a laser diode current.

The invention also relates to a laser light transceiver including a laser light transmitter according to the invention, and a laser light receiver unit having a laser light receiving diode and a receiver circuit connected with the laser light receiving diode.

Furthermore, the invention relates to a method for manufacturing a laser light transmitter according to the invention.

Laser light transmitters and laser light transceivers of this kind for optical communication systems are known and are used in optical fibre networks. An example of such a network is the ATM-PON (Asynchronous Transmission Mode-Passive Optical Network) for offering customers an increased data communication capability. In this system an OLT (Optical Line Terminator) in a Central Office is connected to up to 32 ATM ONT's (Optical Network Termination) which are placed at the customers premises. In an ATM-PON a data signal transmitted from the OLT in the Central Office to an ONT is called a downstream signal. A data signal transmitted from the ONT to the OLT in the Central Office is called an upstream signal.

For generating a downstream signal an electrical signal is converted into an optical signal by a laser light transmitter in the OLT in the Central Office. The optical signal is received in the ONT and converted to an electrical signal by a laser light receiving unit in the ONT. In an ATM-PON network the downstream signal is a continuous wave optical signal.

In a similar manner an upstream optical signal is generated by a laser light transmitter of an ONT. This upstream signal is received by a laser light receiving unit in the OLT. In an ATM-PON network the upstream signal is a burst mode signal.

In the laser light transmitters and laser light transceivers of the known type the transmitter unit includes a monitor diode for measuring the intensity (optical output power) of the transmitted signal of the laser diode, wherein the monitor diode is connected with the laser driver. The laser driver can control the laser diode current on the basis of the measured intensity of the transmitted signal. In this way the laser diode, the monitor diode and the laser driver form a feedback-loop in the transmitter unit, wherein the laser driver is optimised for the specific laser diode. The transmitted signal is a burst mode signal as a result of which the feedback-loop does not receive a feedback-signal outside the burst-interval. The consequence is that the feedback-loop has to be set for every burst. This can be performed by storing control information at the end of the burst and by setting control information again at the beginning of a new burst. However, for this a complicated and expensive driver circuit is required with high speed amplifiers and special switching techniques resulting in complicated, vulnerable and expensive laser light transmitters and laser light transceivers.

Furthermore, laser light transmitters and laser light transceivers of the known type are expensive components, the prices of the said laser light transmitters and transceivers constitute a significant part of the costs of the ONT's. It is therefore an object of the invention to provide a laser light transmitter and/or transceiver which is of a simplified yet reliable design and thereby is considerably cheaper than prior laser light transmitters and/or transceivers.

Finally, it is an object of the invention to provide a flexible laser light transmitter and/or transceiver wherein the laser diode is independent of the laser driver such that the laser diode can for example be replaced without the need of replacing the laser driver.

In order to achieve the said objectives of the invention the laser light transmitter according to the invention is characterised in that the microprocessor is connected with the laser driver and with the temperature sensor, wherein, in use, the microprocessor controls the laser driver on the basis of at least predetermined temperature related characteristics of the laser diode and the temperature measured by the temperature sensor. This results in a robust and relatively cheap laser light transmitter, wherein the laser light transmitter applies a feed forward control principle. Also, in this manner the laser light transmitter or laser light transceiver can, in a flexible way, be adapted to other laser diode characteristics when, for example, a laser diode has to be replaced by another laser diode or when the laser diode has suffered from aging, by loading the microprocessor with corresponding predetermined temperature related characteristics. The predetermined characteristics of the laser diode can be measured beforehand (for example in the factory). In contrast with known laser light transmitters, the laser light transmitter according to the invention does not need a monitor diode and an expensive feedback loop.

The laser diode characteristics can relate to the relation between the laser diode current, the intensity of the laser output signal (optical output power) and the temperature of the laser diode. Once the desired intensity of the laser signal has been established the microprocessor in the processing unit calculates the required laser diode current using the temperature in the direct surroundings of the laser diode measured by the temperature sensor. Then, the laser driver applies this calculated current to the laser diode which subsequently transmits the laser signal when it is triggered to do so by the laser driver.

Furthermore, the invention relates to a laser light transceiver including a laser light transmitter according to the invention, and a laser light receiver unit having a laser light receiving diode and a receiver circuit connected with the laser light receiving diode. With the laser light transmitter of the transceiver electrical signals can be converted into optical signals and transmitted by the laser diode and with the laser light receiver of the transceiver optical signals can be received and converted into electrical signals. This transceiver is suited for application in networks like the ATM-PON.

The invention also relates to a method for manufacturing a laser light transmitter according to the invention characterised by the steps of determining predetermined characteristics of the laser diode and storing such characteristics in memory means of the processing unit.

In the accompanying drawings, in which certain modes of carrying out the present invention are shown for illustrative purposes:
Figure 1 schematically shows an example of a laser light transmitter circuit according to the invention;
Figure 2 is a diagram illustrating the characteristics of a laser diode;
Figure 3 schematically shows an embodiment of a laser light transceiver according to the invention;

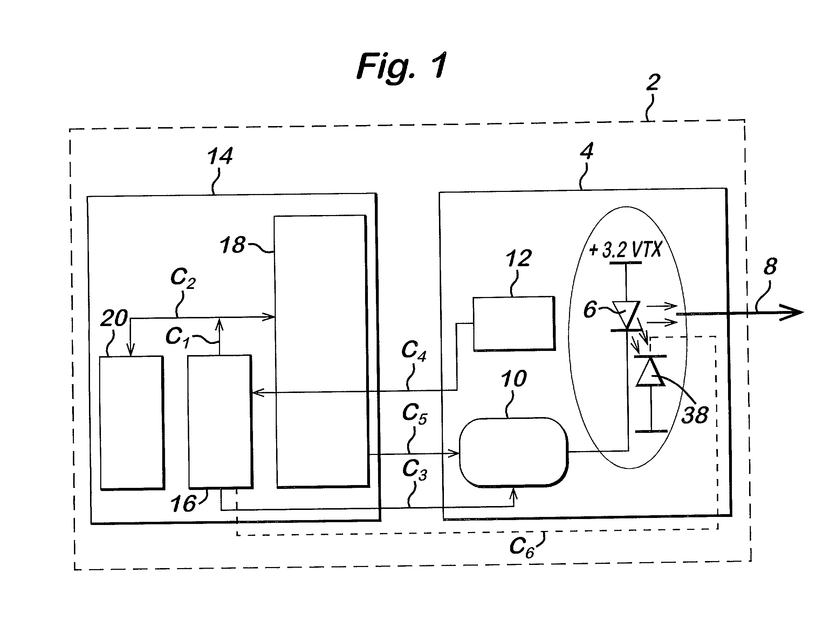

In Figure 1 an embodiment of a laser light transmitter 2 according to the invention is shown. Such a laser light transmitter 2 can be applied in an optical communication system.

The laser light transmitter 2 comprises a transmitter unit 4. The transmitter unit 4 comprises a laser diode 6 and a temperature sensor 12 for measuring the temperature of the laser diode 6. The temperature sensor 12 can be a diode, for example a photodiode. The laser diode 6 is arranged for transmitting a laser signal 8 and is connected with a laser driver 10. The laser signal 8 can be a signal in continuous mode as well as a signal in burst mode and can be transmitted at different intensities by the laser diode 6. These properties of the laser signal 8 are determined by the laser driver 10 by controlling the laser diode current of the laser diode 6. The laser signal 8 may have a wavelength in the range of 1200-1700 nm.

The laser light transmitter 2 also includes a processing unit 14. This processing unit 14 comprises a microprocessor 16, an ASIC (Application Specific Integrated Circuit) 18 and memory means 20. The microprocessor 16 is connected with the ASIC 18 (via connections C₁ and C₂) and with the memory means 20 (via connections C₁ and C₂), and the ASIC 18 is connected with the memory means 20 (via connection C₂).

The transmitter unit 4 in this embodiment has at least three connections with the processing unit 14. A first connection C₃ is between the microprocessor 16 and the laser driver 10. A second connection C₄ is between the microprocessor 16 and the temperature sensor 12, and a third connection C₅ is between the ASIC 18 and the laser driver 10.

During operation of the laser light transmitter 2 the microprocessor 16 controls the laser driver 10 on the basis of predetermined temperature related characteristics of the laser diode 6 via the first connection C₃. Therefore, measurements of the temperature of the laser diode 6 are supplied to the microprocessor 16 by the temperature sensor 12 via the second connection C₄. The microprocessor performs calculations for determining the electrical current which has to be supplied by the laser driver 10 to the laser diode 6. This electrical current controls the intensity of the laser signal 8. The transmission information which has to be modulated on the laser signal 8 is supplied by the ASIC via the third connection C₅. (The source supplying this information to the ASIC is not shown in Figure 1).

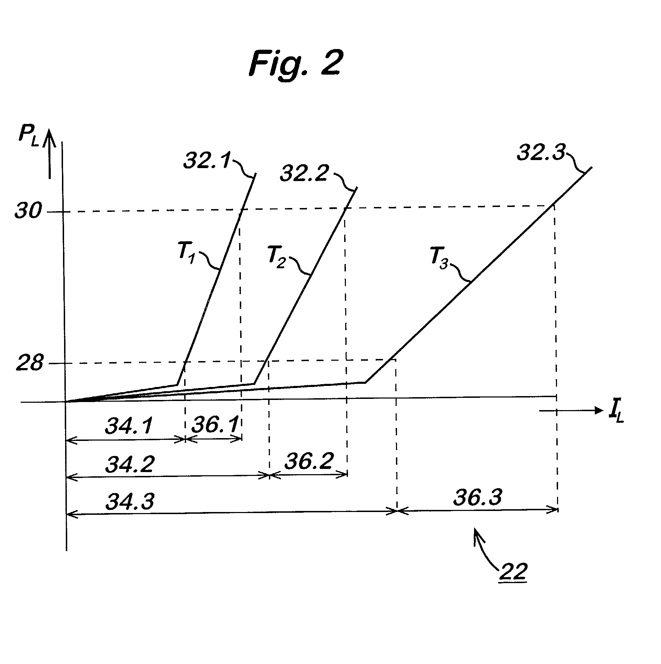

In this example said predetermined characteristics of the laser diode 6 comprise the relation between the laser diode current, the intensity of the laser signal and the temperature of the laser diode. An example of the relation between these parameters for a particular laser diode is diagrammatically illustrated in Figure 2. In Figure 2 a co-ordinate system 22 is shown wherein the laser diode current I_{L} is the running parameter along the horizontal axis and wherein the intensity of the laser signal P_{L} is the running parameter along the vertical axis. In this example digital information is correlated with the intensity of the laser signal 8. In the co-ordinate system 22 two different levels 28 and 30 are marked on the vertical axis. The level 28 indicates a binary "0" and the level 30 indicates a binary "1".

In the co-ordinate system 22 three graphs 32.1, 32.2 and 32.3 are shown. These three respective graphs represents the laser behaviour at three different respective temperatures T₁ = 20 °C, T₂ = 40 °C and T₃ = 60 °C. As shown in the co-ordinate system 22, transmitting a "0" at T₁ requires a laser diode current 34.1. Incrementing the laser diode current 34.1 with the current 36.1 results in that a "1" is transmitted. In a similar manner at temperature T₂ and T₃ respectively a "0" corresponds to current 34.2 and 34.3 respectively and a "1" corresponds to current (34.2+36.2) and (34.3+36.3) respectively. The currents 34.1, 34.2 and 34.3 are called bias-currents and the currents 36.1, 36.2, 36.3 are called modulation-currents. Additionally, also an "OFF" signal level and an "OFF laser diode current" can be defined (not shown in Figure 2). Since the magnitudes of the control currents (the bias current and the modulation current) depend strongly on the temperature of the laser diode it is of importance that the temperature of the laser diode is accurately detected by the temperature sensor 12 and subsequently transmitted to the processing unit 14, in particular the microprocessor 16.

In accordance with the invention said predetermined temperature related characteristics of the laser diode 6 are determined beforehand (for example in the factory) and are stored in the ASIC 18 or in the memory means 20, for instance in table form. The microprocessor 16, the ASIC 18 and the memory means 20 can exchange information of this kind via their connections C₁ and C₂. Thus, the information concerning the predetermined characteristics of the laser diode will always be available in the processing unit 14. However, this information may become inaccurate or even incorrect if the laser diode has suffered from aging. In order to be able to compensate for this effect, for instance, by adjusting the laser diode current, an estimation of the amount of aging has to be made. This may be done by recording the time-temperature history of the laser diode based on information provided by the temperature sensor 12. The microprocessor 16 will then be able to calculate an aging-correction for the predetermined characteristics.

Optionally, the transmitter unit 4 of the laser light transmitter 2 can be arranged with a monitor diode 38 (which is schematically indicated by the dotted lines in Figure 1). The monitor diode 38 in the transmitter unit 4 is connected via a connection C₆ (normally the connection C6 will include a subcircuit for interfacing purposes) with the processing unit 14 (which forms a fourth connection between the transmitter unit 4 and the processing unit 14). The monitor diode 38 can be a photodiode, accommodated in the same housing as the laser diode 6, for measuring the temperature of the laser diode 6. In this case the monitor diode 38 can replace the temperature sensor 12. In an other application of the monitor diode the monitor diode is arranged to receive and to measure the intensity of the laser output signal 8. This offers for example the possibility of compensating for the degree of aging of the laser diode 6 on the basis of the monitor diode current. It is noted that this formally does form a feedback loop. However, this loop operates at a much larger time scale than the feed-forward control provided by the microprocessor 16, laser driver 10 and the laser diode 6. Also the feedback loop of the monitor diode 38 and connection C₆ is quite different from the prior art feedback loop used for the laser diodes, because the monitor diode does not need to distinguish between "OFF", "0" and "1" levels.

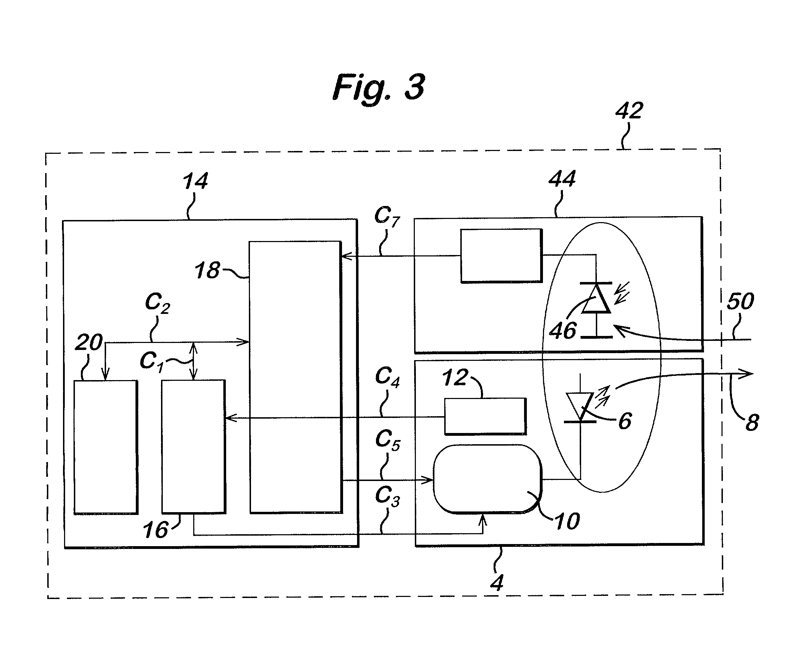

Figure 3 depicts an example of a laser light transceiver 42 according to the invention including a transmitter unit 4, a processing unit 14 and a laser light receiver unit 44. The laser receiving unit 44 comprises a laser light receiving diode 46 which is connected with a receiving circuit 48. The receiving circuit 48 in this example is connected with the ASIC 18 in the processing unit 14 via connection C₇. However it would be possible to use a separate circuit which is not part of the ASIC 18. In operation, the receiving diode 46 of the receiving unit 44 receives a laser signal 50. This optical signal is converted into an electrical signal which is transmitted to the ASIC 18. The electrical signal is further processed in the processing unit 14 in a conventional way. Thus, the laser light transceiver is able to receive laser signals with the receiving unit 44 and is able to transmit laser signals with the transmission unit 4 (the latter is explained in detail hereinbefore). This laser light transceiver is especially suited for application in extensive optical communication networks.

It will be clear to those skilled in the art that the invention can be practised otherwise than as specifically illustrated and described without departing from its spirit or scope.

## Claims

1. A laser light transmitter for an optical communication system, including a transmitter unit having a laser diode for transmitting a laser output signal, and a laser driver which is connected with the laser diode and a temperature sensor for temperature compensation purposes, wherein the laser light transmitter further includes a processing unit including a microprocessor and memory means which are connected with the microprocessor, wherein, in use, the laser driver controls the laser diode by providing the laser diode with a laser diode current, **characterised in that**, the microprocessor is connected with the laser driver and with the temperature sensor, wherein, in use, the microprocessor controls the laser driver on the basis of at least predetermined temperature related characteristics of the laser diode and the temperature measured by the temperature sensor.

2. A laser light transmitter according to claim 1, **characterised in that**, the predetermined characteristics relate to the relation between the laser diode current, the intensity of the laser output signal and the temperature of the laser diode.

3. A laser light transmitter according to one of the preceding claims, **characterised in that**, the transmitter unit comprises a monitor diode for measuring the intensity of the laser output signal, wherein the monitor diode is connected with the microprocessor.

4. A laser light transmitter according to one of the preceding claims, **characterised in that**, the laser light transmitter includes means for recording the time-temperature history of the laser diode for estimating the aging of the laser diode.

5. A laser light transmitter according to anyone of the preceding claims, **characterised in that**, the processing unit includes an Application Specific Integrated Circuit which is at least connected to the microprocessor, the memory means and the laser driver.

6. A laser light transmitter according to claim 5, **characterised in that**, the predetermined temperature related characteristics are stored in table-form in the memory means or in further memory means integrated in the Application Specific Integrated Circuit.

7. A laser light transceiver including a laser light transmitter, according to anyone of the preceding claims, and a laser light receiver unit having a laser light receiving diode and a receiver circuit connected with the laser light receiving diode.

8. A method for manufacturing a laser light transmitter according to anyone of the claims 1-6, **characterised in that**, by the steps of determining predetermined characteristics of the laser diode and storing such characteristics in memory means of the processing unit.

9. A method according to claim 8, **characterised in that**, the predetermined characteristics include temperature related laser properties.
